# EUROPEAN PATENT SPECIFICATION

(11) **EP 4 367 054 B1**
(45) Date of publication and mention of the grant of the patent: **09.12.2026**
(21) Application number: 22741235.0
(22) Date of filing: 30.06.2022
(51) Int. Cl.: B81C 1/00

(54) **USE OF TIN THIN FILM FOR BONDING AND AS MASKING FILM**
VERWENDUNG EINER DÜNNEN ZINNSCHICHT ZUM VERBINDEN UND ALS MASKIERUNGSSCHICHT
UTILISATION D'UN FILM MINCE D'ÉTAIN POUR COLLAGE ET COMME FILM DE MASQUAGE

(30) Priority: 07.07.2021 NO 20210884
(43) Date of publication of application: 15.05.2024
(73) Proprietor: University of South-Eastern Norway, 3603 Kongsberg (NO)
(72) Inventor: ROY, Avisek, 3189 Horten (NO); BARDALEN, Eivind, 3180 Nykirke (NO); ØHLCKERS, Per Alfred, 1394 Nesbru (NO)
(74) Representative: Bryn Aarflot AS
(86) International application number: PCT/EP2022/068101
(87) International publication number: WO 2023/280676

(56) References cited:
- LUU THI-THUY ET AL: "Cu/Sn SLID wafer-level bonding optimization", PROCEEDINGS OF THE 27 TH ELECTRONIC COMPONENTS CONFERENCE (7TH ELECTRONIC COMPONENTS CONFERENCE, STOUFFER'S NATIONAL CENTER INN, ARLINGTON, VA., MAY 16-18, 1977), INSTITUTE OF ELECTRICAL AND ELECTRONICS ENGINEERS, 28 May 2013 (2013-05-28), pages 1531 - 1537, XP032474190, ISSN: 0569-5503, [retrieved on 20130806], DOI: 10.1109/ECTC.2013.6575775
- TZU-YING KUO ET AL: "Reliability tests for a three dimensional chip stacking structure with through silicon via connections and low cost", 58TH ELECTRONIC COMPONENTS AND TECHNOLOGY CONFERENCE - 27-30 MAY 2008 - LAKE BUENA VISTA, FL, USA, IEEE, PISCATAWAY, NJ, USA, 27 May 2008 (2008-05-27), pages 853 - 858, XP031276296, ISBN: 978-1-4244-2230-2

## Description

### Field of the invention

The present invention generally relates to the field of silicon chip and wafer-level packaging (CLP and WLP) of silicon microsystems including MicroElectromechanical Systems (MEMS) having silicon micromachined structures such as cavities. The CLP and WLP are done by Solid-Liquid-InterDiffusion (SLID) bonding and the structure or cavity etching is done by dry etching such as Deep Reactive Ion Etching or wet etching by anisotropic wet etching. The present invention relates to the use of tin (Sn) as the surface metal layer used both as a part of the metal layers used in the SLID bonding and also used as the etching mask film during silicon micromachining.

### Background of the invention

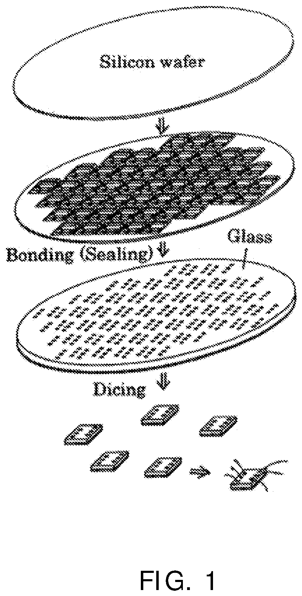

Microsystems devices including MEMS devices are widely used, having sensor and/or actuating functionality, often combined with microelectronics and using microelectronic fabrication technologies to achieve high performance at low cost. Examples of such successful devices include MEMS pressure sensor, accelerometer, gyroscope, microbolometer, RF switch, etc. Bosch, Honeywell, IMEC, Infineon, MEMSCAP, Philips, Semefab, Sensonor, Sony, STMicroelectronics, Tronics, TSMC, Xfab are some of the leading companies that commercially produce such microsystems. MEMS devices are often encapsulated for mechanical, electrical and/or chemical protection of the sensitive and vulnerable microstructures. Some devices also require vacuum encapsulation with hermetic sealing for ensuring proper functionality of the sensors. The encapsulation is mostly done by sealing the microsystem with a cap / lid in chip or wafer level (Fig. 1). There are numerous bonding methods for encapsulating the MEMS device with the cap including SLID bonding [1-3], where metal layers are used for bonding of the two chips / wafers.

The chips are bonded together as chips (CLP) or on wafer-level (WLP) for each actual product, depending on specific preferences on technical capability and cost consideration, with WLP packaging preferred for high volume products justifying higher NonRecurring Engineering (NRE) costs. Apart from low packaging cost, WLP also reduces testing and burn-in costs while providing high throughput. SLID bonding process can be used in both chip and wafer-level packaging, while it can provide hermetic sealing at relatively low temperatures. In SLID, Sn is a commonly used material due to its low melting temperature (~ 232 °C). During the metal deposition for sealing frames, Sn layer is often stacked on top of Cu, Au, Ag, Ni or Cu-Ni [3-6].

In US 2017225947 [9] a conventional method is described using a photoresist over the Sn layer before cavity etching, while US2021202249 [10] and KR20160146126 [11] describes processing of semiconductor substrates.

In LUU THI-THUY ET AL: "Cu/Sn SLID wafer-level bonding optimization",PROCEEDINGS OF THE 27 TH ELECTRONIC COMPONENTS CONFERENCE (7TH ELECTRONIC COMPONENTS CONFERENCE, STOUFFER'S NATIONAL CENTER INN, ARLINGTON, VA., MAY 16-18, 1977), INSTITUTE OF ELECTRICAL AND ELECTRONICS ENGINEERS, 28 May 2013 (2013-05-28), pages 1531-1537, a method for micromachining a silicon structure is described. The method comprises the steps of preparing a silicon wafer with a metal pattern on said silicon, a step of etching of the structure for etching cavities without etching the Au top layer, and a metal layer (TiW) is been provided between said silicon wafer and said metal pattern, the method including an initial step of performing a wet etching removing said Au top layer.

Document TZU-YING KUO ET AL: "Reliability tests for a three dimensional chip stacking structure with through silicon via connections and low cost",58TH ELECTRONIC COMPONENTS AND TECHNOLOGY CONFERENCE - 27-30 MAY 2008 - LAKE BUENA VISTA, FL, USA, IEEE, PISCATAWAY, NJ, USA, 27 May 2008 (2008-05-27), pages 853-858, ISBN: 978-1-4244-2230-2 discloses the use of Tin as a masking layer for a subsequent etching step.

### Summary of the invention

The present invention provides a process for the combined use of tin (Sn) thin film as the SLID top layer metal layer and as the masking film during silicon micromachining. In this way, two separate deposition and photolithographic processes can be done as one deposition and photolithographic process reducing the needed process steps and, also give self-alignment between the silicon micromachined structure and the SLID sealing pattern. In a typical cap wafer fabrication process, the sealing metal is protected with photoresist when the cavity is formed by selective Si etching [7,8]. In the proposed fabrication method, the entire wafer is etched, except for the areas covered by the sealing metal. In this case, the exposed sealing metal layer acts as the mask for the Si cavity etching. It is therefore an object of the present invention to provide a production method with reduced cap wafer processing steps, which will increase yield and reduce the batch processing cost, resulting in lower unit cost for the finished product.

More specifically, the objects of the present invention is obtained as specified in the accompanying claims.

The invention will be described more in detail below with reference to the accompanying drawings illustrating the invention by way of examples.
- Figure 1: illustrates the wafer packaging according to the prior art.
- Figure 2: illustrates the wafer processing according to one example of the prior art as well as according to the preferred embodiment of the invention.
- Fugure 3: illustrates a corner of a bond frame after deposition of SLID metals.
- Figure 4: illustrates an EDX analysis of bond frame (a) before and (b) after USM layer etching.
- Figure 5: illustrates cavity formation by Si DRIE - (a) etched wafer, (b) electron micrograph of the bond frame, and (c) profilometer measurement.
- Figure 6: illustrates cavity formation by Si wet etching - (a) etched wafer, (b) electron micrograph of the bond frame, and (c) profilometer measurement.
- Figure 7: illustrates EDX analysis of bond frame - (a) before cavity etching and (b) after cavity wet etching.

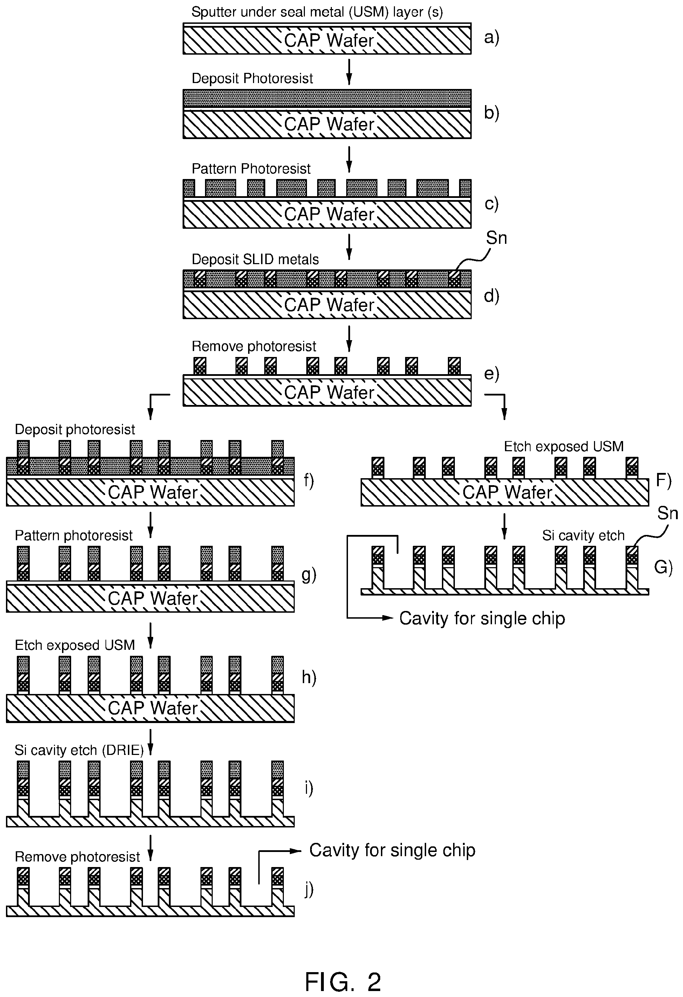

As is illustrated in figure 2 the wafer is may be processed according to the following steps:
a) Depositing, e.g. by sputtering, a metal layer (under seal metal layer USM) on a silicon wafer.
b) Depositing a photoresist layer.
c) Providing a patter in said photoresist layer making recesses down to said USM in a predetermined pattern.
d) Depositing SLID metals in said recesses, e.g. with Sn in the top layer.
e) Removed said photoresist.

From this point the prior art process would continue by the steps of:
f) Depositing a new photoresist covering the SLID metal deposits.
g) Remove the photoresist between the SLID metal deposits by patterning the photoresist exposing the USM between them..
h) Etch the exposed USM.
i) Use DRIE etching for etching the silicon between the SLID metal deposits still being covered by photoresist.
j) Remove the photoresist exposing the Sn on top of the SLID metal structures..

The present invention is based on the realization that the Sn metal does not react to the etching and thus a simplified process may be used, including the steps following step e):
F) Removing the USM between the USM between the SLID metal structures.
G) Etching cavities in the silicon wafer between the SLID metal structures.

The fabrication is discussed more in detail below. Fabrication of the cap wafer starts with deposition of under seal metal (USM) layers on a silicon wafer. The USM layers can also be deposited on oxidized Si wafers to prevent metal diffusion to bulk silicon, where a thin layer of silicon dioxide (~200-500 nm) is grown by thermal oxidation. In our demonstration, Cu-Sn SLID bonding technique was chosen, where Au and TiW were used as the USM layers. A thin adhesion layer like TiW is first deposited as the adhesion layer between the Si or SiO₂ surface and the Au seed layer followed by the Au layer, both using sputtering.

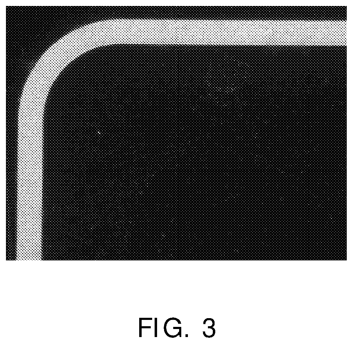

A photolithographic process is then performed to define the bond frame regions (Fig. 2). Then SLID metal layers are electroplated on the opening where Au surface is exposed. Cu is first electroplated on Au, and then Sn is electroplated on Cu. The electrodeposited Cu and Sn thickness are ~3-5 µm and ~1-3 µm, respectively. After deposition of these SLID metal layers, the photoresist is removed. One side of the bond frame is shown in Fig. 3, where the topmost layer is Sn, where Figure 3 shows a corner of a bond frame after deposition of SLID metals.

The deposition process to prepare the bond frames on the cap wafer is part of a typical process flow as shown in Fig. 2. However, as illustrated, typical micromachining of cap wafer requires several steps, where photolithography steps are performed again to protect the top metal layer on the bond frames. In our proposed approach, we have shown micromachining of cap wafer with Sn as the etching mask, where the photolithographic steps are avoided. This approach simplifies the process while reducing both processing time and cost for the cap wafers.

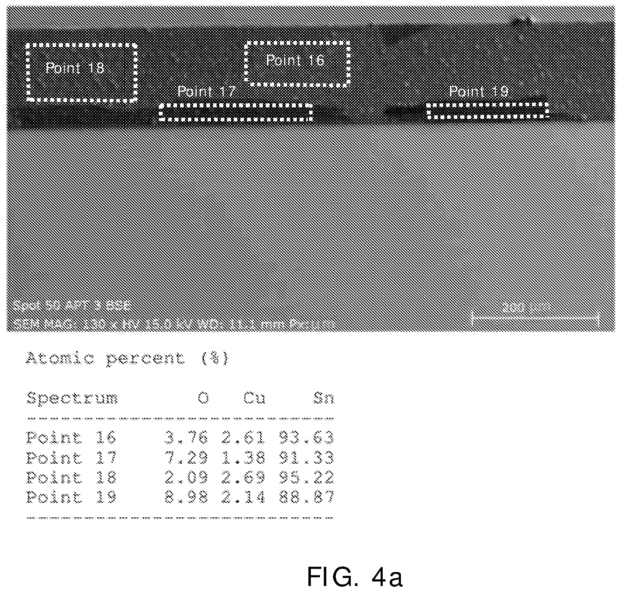

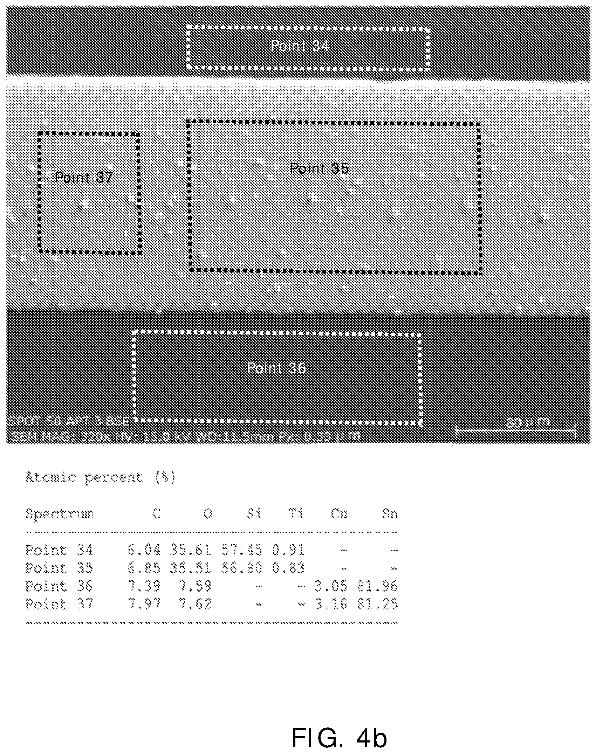

In the proposed method, steps F) and G) in Fig. 2b, the exposed Au and TiW layers are wet etched. Energy-dispersive X-ray spectroscopy (EDX) analysis of a bond frame is shown in Fig. 4. Before the etching of USM layers, average atomic percentage of Sn in the bond frame is over 92%. After USM layer etching, there is a reduction in Sn percentage. Most of which is due to carbon. If carbon is not taken into consideration (similar to previous analysis), then Sn % will increase. This indicates some amount of Sn etching during the process. As the Sn is not significantly etched, it will not affect the SLID bonding process. During electrodeposition, the Sn thickness can be increased accordingly to compensate for this.

The next processing step before Si cavity etching can be etching the exposed SiO₂ layer if oxidized Si wafer is used. In our process, oxidized Si wafers were used. Hence, SiO₂ layer was etched by reactive ion etching (RIE), where CHF₃ was used as the primary reactive gas. The final step is etching Si to form the cavity of the cap wafer. Cavity micromachining with Sn as mask is successfully demonstrated in both DRIE and wet Si etching approaches.

### (a) Cavity formation by Si DRIE

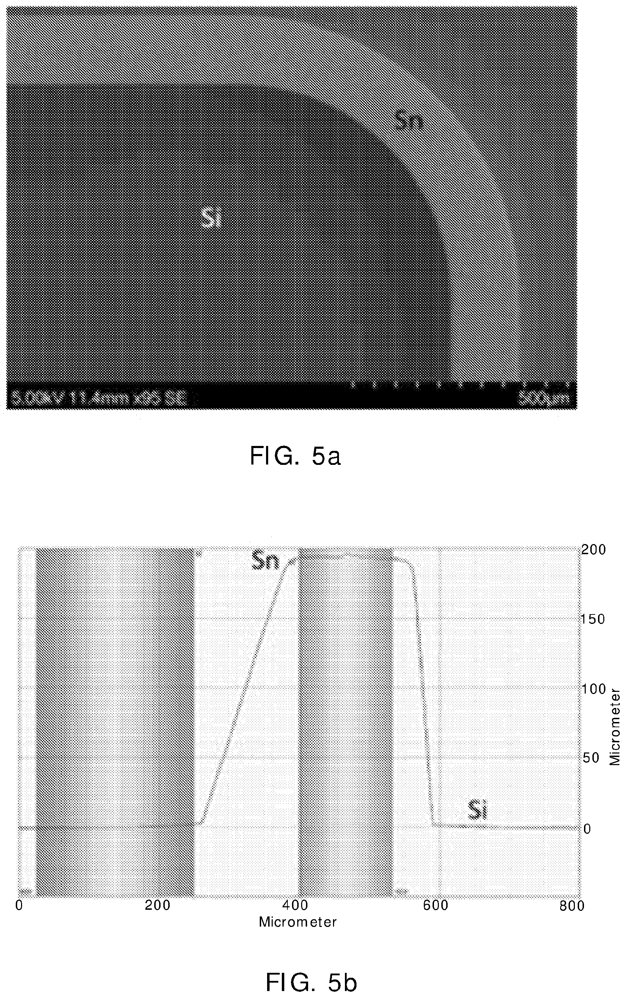

A typical Bosch DRIE technique was used for etching the bulk Si. SF₆ is used for the plasma etching process, where C₄F₈ is used for the passivation layer on the sidewalls. The Sn layer on the bond frames was exposed during the process and acted as mask for micromachining the cavity (Fig. 5). The etched cavity was ~200 µm.

Atomic percentage of Sn remains high compared to the results obtained before the cavity etching (Fig. 4b). This indicates insignificant impact on the bond frame during the DRIE process. Therefore, Sn can be used as the mask for the cavity etching with Si DRIE.

### (b) Cavity formation by Si wet etching

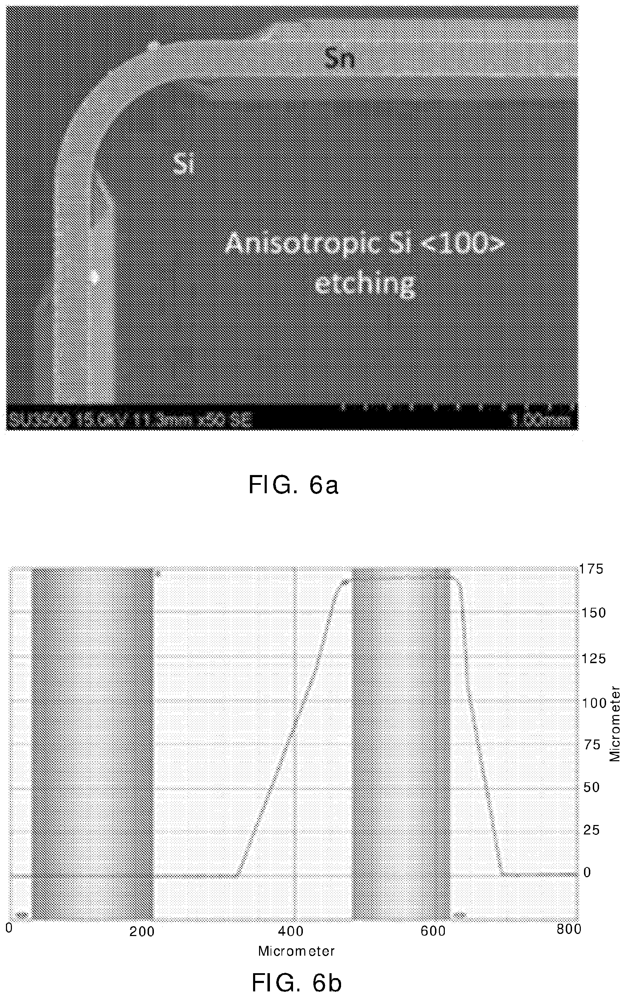

The cavity of the cap wafer was also micromachined by Si wet etching as shown in Fig. 6. The wafer was etched with 10 % KOH at 80 °C which resulted in anisotropic Si etching (Fig. 6b). ~170 µm cavity was formed with ~1.42 µm/min etch rate. The etching was uniform across the wafer.

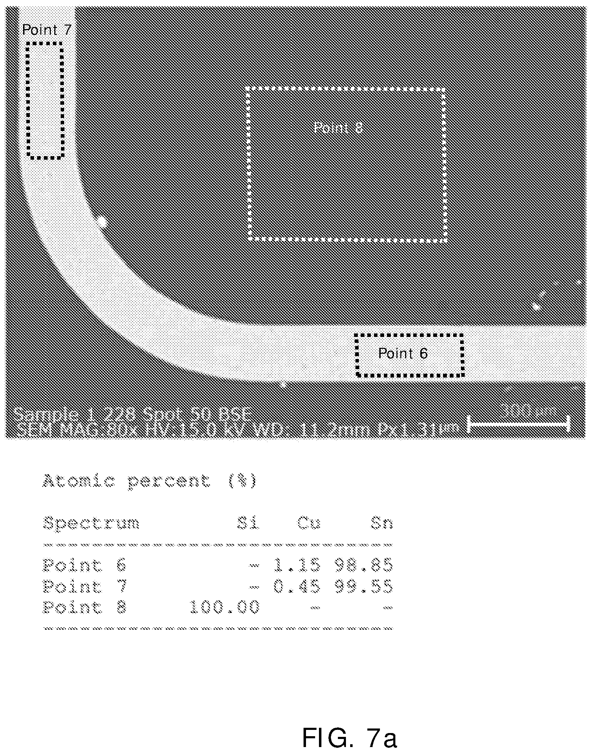

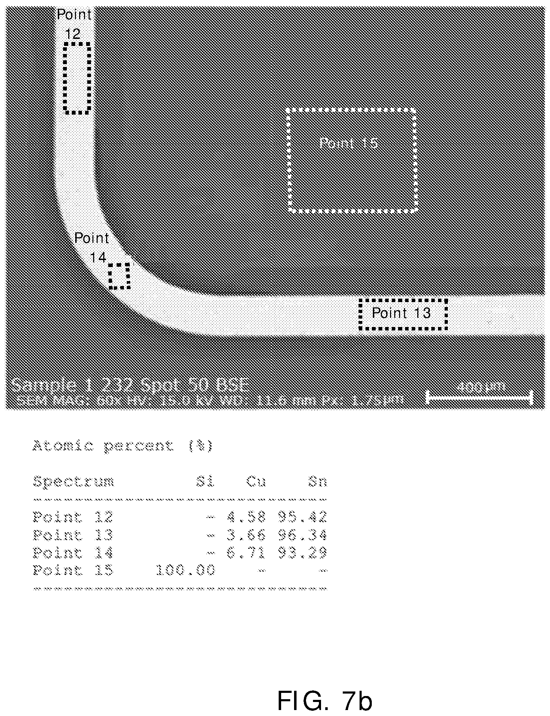

Results of EDX analysis before and after cavity wet etching are shown in Fig. 7. The reduction in the atomic percentage of Sn after the cavity etching is insignificant. Therefore, Sn can also be used as a mask while cavity is formed on the Si bulk by wet etching.

### SLID bonding of the chip or wafer stack

Our process demonstrates that Sn can be used as a mask for Si micromachining by both wet and dry etching approaches. In our demonstration, Sn is used as the bond frame metal layer for Cu-Sn SLID bonding. By using Sn as mask for the Si cavity etching, several processing steps involving photolithography are avoided. This makes the fabrication of cap wafers for the SLID bonding simpler while saving time and cost.

To summarize the present invention thus relates to a method for micromachining a silicon structure especially for SLID bonding. The method comprises the steps of preparing a silicon wafer with a metal pattern on said silicon where the silicon is exposed outside the pattern. The metal pattern at least being constituted by an upper surface constisting of Sn and the method comprises a step of DRIE etching of the structure for etching cavities in said exposed silicon wafer essentially without etching said Sn top layer.

A metal layer (USM) may be provided as an adhesion layer said silicon wafer surface, being constituted by Si or SiO and the metal pattern. The method then including an initial step before said DRIE etching, said performing a wet etching removing said USM layer outside thus exposing said silicon outside said metal pattern, the USM metal being at least one of Au and TiW.

The DRIE etching will preferably include reactive ion etching with CHF3 being the primary driving gas and the wet etching process may preferably be based on a 10%KOH at 80°C.

The metal pattern may be constituted by a Sn layer stacked on top of at least one of Cu, Au, Ag, Ni or Cu-Ni, constituting a SLID metal pattern suitable for SLID bonding process, and preferably a Cu layer with an upper Sn layer. In this case the SLID bonding may be constituted by bonding a corresponding Cu-Sn pattern on said metal pattern providing a Cu-Sn SLID bonding, with a resulting Cu3Sn layer between the Cu layers.

According another aspect the present invention relates to a Sn metal pattern on a silicon wafer being used as an etching mask during an etching process including a DRIE etch process.

According yet another aspect the present invention relates the use of a Sn metal pattern on a silicon wafer wherein the wafer is covered with a USM metal layer, where the Sn metal layer is used as an etching mask during an etching process including a wet etch process, the USM metal being at least one of Au or TiW metal.

### References:

1. Lapadatu, A.; Simonsen, T.I.; Kittilsland, G.; Stark, B.; Hoivik, N.; Dalsrud, V.; Salomonsen, G. Cu-Sn Wafer Level Bonding for Vacuum Encapsulation of Microbolometer Focal Plane Arrays. ECS Trans. 2010, 33, 73-82.
2. Luu, T.-T.; Hoivik, N.; Wang, K.; Aasmundtveit, K.E.; Vardøy, A.-S.B. High-Temperature Mechanical Integrity of Cu-Sn SLID Wafer-Level Bonds. Metall. Mater. Trans. A 2015, 46, 5266-5274.
3. Xu, H.; Suni, T.; Vuorinen, V.; Li, J.; Heikkinen, H.; Monnoyer, P.; Paulasto-Kröckel, M. Wafer-level SLID bonding for MEMS encapsulation. Adv. Manuf. 2013, 1, 226-235.
4. Larsson, A.; Tollefsen, T.A.; Aasmundtveit, K.E. Ni-Sn solid liquid interdiffusion (SLID) bonding - Process, bond characteristics and strength. In Proceedings of the 2016 6th Electronic System-Integration Technology Conference (ESTC); 2016; pp. 1-6.
5. Aasmundtveit, K.E.; Tollefsen, T.A.; Luu, T.; Duan, A.; Wang, K.; Hoivik, N. Solid-Liquid Interdiffusion (SLID) bonding - Intermetallic bonding for high temperature applications. In Proceedings of the 2013 Eurpoean Microelectronics Packaging Conference (EMPC); 2013; pp. 1-6.
6. Laurila, T.; Vuorinen, V.; Kivilahti, J.K. Interfacial reactions between lead-free solders and common base materials. Mater. Sci. Eng. R Reports 2005, 49, 1-60.
7. Hilton, A.; Temple, D.; Lannon, J.; Schimert, T.; Skidmore, G.; Gooch, R.; Trujillo, C.; Miskimins, S.; Li, C. Wafer-level vacuum packaging of microbolometer-based infared imagers. In Proceedings of the Proceedings of the International Wafer-Level Packaging Conference, San Jose, CA, USA; 2016.
8. Wang, X.; Bleiker, S.J.; Edinger, P.; Errando-Herranz, C.; Roxhed, N.; Stemme, G.; Gylfason, K.B.; Niklaus, F. Wafer-Level Vacuum Sealing by Transfer Bonding of Silicon Caps for Small Footprint and Ultra-Thin MEMS Packages. J. Microelectromechanical Syst. 2019, 28, 460-471.
9. US2017225947
10. US2021202249
11. KR20160146126

## Claims

1. Method for micromachining a silicon structure especially for SLID bonding, comprising the steps of preparing a silicon wafer with a metal pattern on said silicon, said silicon being exposed outside said pattern, the metal pattern at least having an upper surface consisting of Sn,
the method comprising a step of DRIE etching of the structure for etching cavities in said exposed silicon wafer essentially without etching said Sn top layer, and wherein
a metal layer (USM) has been provided between said silicon wafer and said metal pattern, the method including an initial step before said DRIE etching, said initial step consisting in performing a wet etching removing said USM layer outside the Sn top layer thus exposing said silicon outside said metal pattern, the USM metal being at least one of Au and TiW.

2. Method according to claim 1, wherein said DRIE etching includes reactive ion etching with CHF₃ being the primary driving gas.

3. Method according to claim 2, wherein the wet etching process was based on a 10%KOH at 80°C.

4. Method according to claim 1, wherein the metal pattern is constituted by a Sn layer stacked on top of at least one of Cu, Au, Ag, Ni or Cu-Ni, constituting a SLID metal pattern suitable for SLID bonding process.

5. Method according to claim 5, wherein the metal patterns is constituted by a Cu layer and an Sn layer.

6. Method according to claim 6, wherein said SLID bonding is constituted by bonding a corresponding Cu-Sn pattern on said metal pattern providing a Cu-Sn SLID bonding, with a resulting Cu₃Sn layer between the Cu layers.

7. Use of a Sn metal pattern on a silicon wafer as an etching mask during an etching process including a DRIE etch process.

8. Use according to claim 7, wherein the silicon wafer is covered with a USM metal layer separating the Sn pattern from the silicon wafer, the USM metal being at least one of Au or TiW metal.

## Patentansprüche

1. Verfahren zum Mikrobearbeiten einer Siliziumstruktur, insbesondere für eine SLID-Bindung, umfassend die Schritte eines Vorbereitens einer Siliziumscheibe mit einem Metallmodell auf dem Silizium, wobei das Silizium außerhalb des Modells freiliegt, wobei das Metallmodell mindestens eine obere Schicht aufweist, die aus Sn besteht,
das Verfahren umfassend einen Schritt eines DRIE-Ätzens der Struktur zum Ätzen von Hohlräumen in der freiliegenden Siliziumscheibe im Wesentlichen ohne das Ätzen der Sn-Deckschicht und wobei
eine Metallschicht (USM) zwischen der Siliziumscheibe und dem Metallmodell bereitgestellt wurde, wobei das Verfahren einen anfänglichen Schritt vor dem DRIE-Ätzen einschließt, wobei der anfängliche Schritt aus einem Durchführen eines Nassätzens besteht, wobei die USM-Schicht außerhalb der Sn-Deckschicht entfernt wird, wodurch das Silizium außerhalb des Metallmodells freigelegt wird, wobei das USM-Metall mindestens eines von Au und TiW ist.

2. Verfahren nach Anspruch 1, wobei das DRIE-Ätzen ein reaktives Ionenätzen mit CHF₃ als primärem Treibgas einschließt.

3. Verfahren nach Anspruch 2, wobei der Nassätzprozess auf einer 10 % KOH bei 80 °C basiert.

4. Verfahren nach Anspruch 1, wobei das Metallmodell durch eine Sn-Schicht gebildet wird, die auf mindestens einem von Cu, Au, Ag, Ni oder Cu-Ni gestapelt ist, wobei ein SLID-Metallmodell gebildet wird, das für einen SLID-Bindungsprozess geeignet ist.

5. Verfahren nach Anspruch 5, wobei die Metallmodelle durch eine Cu-Schicht und eine Sn-Schicht gebildet werden.

6. Verfahren nach Anspruch 6, wobei die SLID-Bindung durch ein Binden eines entsprechenden Cu-Sn-Modells auf dem Metallmodell gebildet wird, wobei eine Cu-Sn-SLID-Bindung mit einer resultierenden Cu₃Sn-Schicht zwischen den Cu-Schichten bereitgestellt ist.

7. Verwendung eines Sn-Metallmodells auf einer Siliziumscheibe als eine Ätzmaske, während eines Ätzprozesses, der einen DRIE-Ätzprozess einschließt.

8. Verwendung nach Anspruch 7, wobei die Siliziumscheibe mit einer USM-Metallschicht bedeckt ist, die das Sn-Modell von der Siliziumscheibe trennt, wobei das USM-Metall mindestens eines von Au- oder TiW-Metall ist.

## Revendications

1. Procédé de micro-usinage d'une structure en silicium, en particulier pour un collage SLID, comprenant les étapes consistant à préparer une tranche de silicium avec un motif métallique sur ledit silicium, ledit silicium étant exposé à l'extérieur dudit motif, le motif métallique ayant au moins une surface supérieure constituée de Sn,
le procédé comprenant une étape de gravure DRIE de la structure pour graver des cavités dans ladite tranche de silicium exposée essentiellement sans graver ladite couche supérieure de Sn, et dans lequel
une couche métallique (USM) a été disposée entre ladite plaquette de silicium et ledit motif métallique, le procédé comprenant une étape initiale avant ladite gravure DRIE, ladite étape initiale consistant à effectuer une gravure humide éliminant ladite couche USM à l'extérieur de la couche supérieure de Sn, exposant ainsi ledit silicium à l'extérieur dudit motif métallique, le métal USM étant au moins l'un parmi Au et TiW.

2. Procédé selon la revendication 1, dans lequel ladite gravure DRIE comprend une gravure par ions réactifs, le CHF₃ étant le gaz d'entraînement principal.

3. Procédé selon la revendication 2, dans lequel le processus de gravure humide était basé sur un KOH à 10 % à 80 °C.

4. Procédé selon la revendication 1, dans lequel le motif métallique est constitué d'une couche de Sn empilée sur au moins l'un parmi Cu, Au, Ag, Ni ou Cu-Ni, constituant un motif métallique SLID approprié pour un procédé de liaison SLID.

5. Procédé selon la revendication 5, dans lequel les motifs métalliques sont constitués d'une couche de Cu et d'une couche de Sn.

6. Procédé selon la revendication 6, dans lequel ladite liaison SLID est constituée par l'assemblage d'un motif Cu-Sn correspondant sur ledit motif métallique fournissant une liaison SLID Cu-Sn, avec une couche de Cu₃Sn résultante entre les couches de Cu.

7. Utilisation d'un motif de métal Sn sur une tranche de silicium en tant que masque de gravure lors d'un procédé de gravure comprenant un procédé de gravure DRIE.

8. Utilisation selon la revendication 7, dans laquelle la tranche de silicium est recouverte d'une couche de métal USM séparant le motif de Sn de la tranche de silicium, le métal USM étant au moins l'un parmi le métal Au ou TiW.
